# EUROPEAN PATENT APPLICATION

(11) **EP 4 542 840 A1**
(43) Date of publication of application: **23.04.2025**
(21) Application number: 23884929.3
(22) Date of filing: 31.10.2023
(51) Int. Cl.: H02M 7/48, H02P 27/06, H01L 23/48

(54) **POWER MODULE FOR MOTOR**

(30) Priority: 31.10.2022 CN 202222885206 U
(71) Applicant: XPT EDS (Hefei) Co., Ltd., Hefei City, Anhui 230601 (CN)
(72) Inventor: QI, Fang, Shanghai 201804 (CN); YU, Yangqingyu, Shanghai 201804 (CN); ZHAO, Zihao, Shanghai 201804 (CN); WANG, Xiaogang, Shanghai 201804 (CN); LI, Daohui, Shanghai 201804 (CN)
(74) Representative: Vossius & Partner Patentanwälte Rechtsanwälte mbB
(86) International application number: PCT/CN2023/128475
(87) International publication number: WO 2024/094000

(57) **Abstract**

The invention relates to the technical field of motor control, and specifically provides a power module for an electric motor, which aims to solve the problem of an existing motor power module of increase of loss of the power module at high frequencies caused by increase of loss during switching on and off due to high stray inductance of a main loop. To this end, the power module of the invention comprises a first positive terminal, a first negative terminal, a second negative terminal and a second positive terminal which are arranged in sequence, wherein a first current loop is formed between the first positive terminal and the first negative terminal, and a second current loop is formed between the first positive terminal and the second negative terminal; and a third current loop is formed between the second positive terminal and the first negative terminal. According to the invention, compared with the prior art, one negative terminal is added, such that an overlapping area of the second current loop and the third current loop is increased to expand the magnetic flux cancellation region, thereby achieving the purpose of reducing stray inductance.

## Description

The invention claims the priority to Chinese Patent Application No. CN 202222885206.X, filed on October 31, 2022, and entitled "POWER MODULE FOR ELECTRIC MOTOR", which is incorporated herein by reference in its entirety.

### Technical Field

The invention relates to the technical field of motor control, and in particular to a power module for an electric motor.

### Background Art

A power module, also known as an inverter module, converts direct-current voltage of an input module into three-phase alternating-current power supply for driving a motor through a switching action of an insulated gate bipolar transistor (IGBT) in the power module.

In the prior art, in a three-phase alternating-current motor drive system, high-frequency carriers are commonly used for high-speed transistor on/off drive for a power semiconductor device. High switching frequency can ensure the effective torque of the motor and reduce the loss, temperature and noise of the motor itself. However, increasing the switching frequency may also increase the power consumption of the power module, and the power consumption of the power module is greatly affected by stray inductance of a main loop. However, the existing motor power modules have high stray inductance of a main loop, which results in the increase of loss during switching on and off and thus results in the increase of loss of the power module at high frequencies.

Accordingly, the invention provides a power module for an electric motor, in order to solve the above technical problem.

### Summary

The invention aims to solve the above technical problem, that is, to solve the problem of an existing motor power module of increase of loss of the power module at high frequencies caused by increase of loss during switching on and off due to high stray inductance of a main loop.

To this end, the invention provides a power module for an electric motor, the power module including a first positive terminal, a first negative terminal, a second negative terminal and a second positive terminal which are arranged in sequence, where
a first current loop is formed between the first positive terminal and the first negative terminal, and a second current loop is formed between the first positive terminal and the second negative terminal; and
a third current loop is formed between the second positive terminal and the first negative terminal, and a fourth current loop is formed between the second positive terminal and the second negative terminal;
the first current loop and the second current loop have the same current flow direction, the third current loop and the fourth current loop have the same current flow direction, and the first current loop and the third current loop have opposite current flow directions; and
the second current loop and the third current loop are capable of forming an overlapping loop area located between the first negative terminal and the second negative terminal to enable cancellation of magnetic fluxes generated by the second current loop and the third current loop in the overlapping loop area.

In a specific implementation of the power module for an electric motor described above, the current flow direction of the first current loop and the second current loop is a counter-clockwise direction, and the current flow direction in the third current loop and the fourth current loop is a clockwise direction.

In a specific implementation of the power module for an electric motor described above, the first positive terminal, the first negative terminal, the second negative terminal and the second positive terminal are fixed to a DC terminal of the power module by ultrasonic wire bonding.

In a specific implementation of the power module for an electric motor described above, the power module further includes a substrate on which the first positive terminal, the first negative terminal, the second negative terminal and the second positive terminal are fixed by ultrasonic wire bonding.

In a specific implementation of the power module for an electric motor described above, the power module further includes a chip welded on the substrate.

In a specific implementation of the power module for an electric motor described above, the first positive terminal correspondingly forms the first current loop and the second current loop with the first negative terminal and the second negative terminal, respectively, via the substrate and the chip.

In a specific implementation of the power module for an electric motor described above, the second positive terminal correspondingly forms the third current loop and the fourth current loop with the first negative terminal and the second negative terminal, respectively, via the substrate and the chip.

In a specific implementation of the power module for an electric motor described above, the power module further includes a plastic housing and a heat sink, where the plastic housing and the substrate are both fixed to the heat sink, and the substrate is encapsulated inside the plastic housing by an encapsulation adhesive.

In a specific implementation of the power module for an electric motor described above, one ends of the first positive terminal, the second positive terminal, the first negative terminal and the second negative terminal extend to the outside of the plastic housing.

In a specific implementation of the power module for an electric motor described above, the substrate is a copper-clad ceramic substrate.

With the above technical solution, the first negative terminal and the second negative terminal are arranged between the first positive terminal and the second positive terminal, that is, compared with the prior art, one negative terminal is added, such that an overlapping area of the second current loop and the third current loop is increased, that is, the magnetic flux cancellation region is expanded, which achieves the purpose of reducing the stray inductance of the main loop, in turn reduces the loss during switching on and off, and finally reduces the loss of the power module at high frequencies. That is, according to the invention, the influence of the stray inductance on the power module is reduced by changing the number and arrangement of the terminals, thereby improving that reliability of electric motor drive control.

### Brief Description of the Drawings

Preferred implementations of the invention are described below with reference to the accompanying drawings, in which:
FIG. 1 is a schematic diagram of the arrangement of terminals and the formation of current loops in a power module in the prior art;
FIG. 2 is a schematic diagram of a structure of a power module for an electric motor according to the invention; and
FIG. 3 is a schematic diagram of current loops formed by a first positive terminal, a first negative terminal, a second negative terminal and a second positive terminal.

### List of reference signs:

1. substrate; 2. chip; 3. first positive terminal; 4. first negative terminal; 5. second negative terminal; 6. second positive terminal; 7. overlapping loop area.

### Detailed Description of Embodiments

Preferred implementations of the invention will be described below with reference to the accompanying drawings. Those skilled in the art should understand that these implementations are merely used to explain the technical principles of the invention, and are not intended to limit the scope of protection of the invention. Those skilled in the art can make adjustments to the implementations according to requirements, so as to adapt to specific application scenarios.

It should be noted that, in the description of the invention, the terms that indicate the direction or positional relationship, such as "upper", "lower", "left", "right", "inner" and "outer", are based on the direction or positional relationship shown in the accompanying drawings, which is merely for ease of description instead of indicating or implying that the related device or element must have a particular orientation and be constructed and operated in a particular orientation, and therefore, should not be construed as limiting the invention. In addition, the ordinal numbers such as "first" and "second" are merely used for the illustrative purpose, and should not be construed as indicating or implying relative importance.

In addition, it should also be noted that, in the description of the invention, the terms "mount" and "connect" should be interpreted in a broad sense unless explicitly defined and limited otherwise. For example, the terms may mean a fixed connection, a detachable connection or an integral connection; may be a mechanical connection or an electrical connection; may be a direct connection, or an indirect connection by means of an intermediate medium. For those skilled in the art, the specific meanings of the foregoing terms in the invention can be interpreted according to a specific situation.

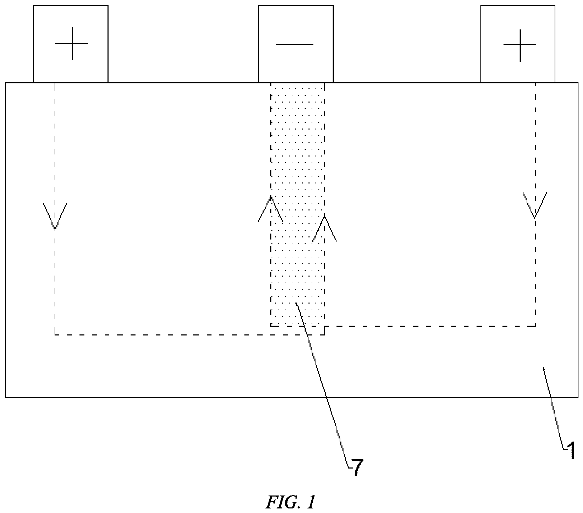

First, reference is made to FIG. 1. FIG. 1 a schematic diagram of a structure of arrangement of terminals in a power module in the prior art. In the prior art, encapsulation of the power module increases loop inductance. During normal operation, only one sides of upper and lower transistors are switched on, such that current flows from DC+ to AC/from AC to DC-. In practice, the inductance of a loop formed from DC+ to a chip 2 and then back to DC- is generally used to represent the overall inductance. The area of the current loop determines the magnetic flux and thus the level of self-inductance. Moreover, the magnetic fluxes formed by opposite current loops may cancel each other out, thereby achieving the purpose of reducing stray inductance.

Continuing to refer to FIG. 1, the power module includes two positive terminals and a negative terminal, where the negative terminal is located between the two positive terminals, and current loops are respectively formed between the two positive terminals and the negative terminal, so as to form two current loops which have opposite current directions and partially overlap, that is, magnetic induction lines generated by the two current loops have opposite directions, such that the magnetic fluxes in the region can cancel out by overlapping, thereby reducing the stray inductance. However, the overlapping area is relatively small, such that the reduction of the stray inductance is small, which still cannot meet the usage requirements.

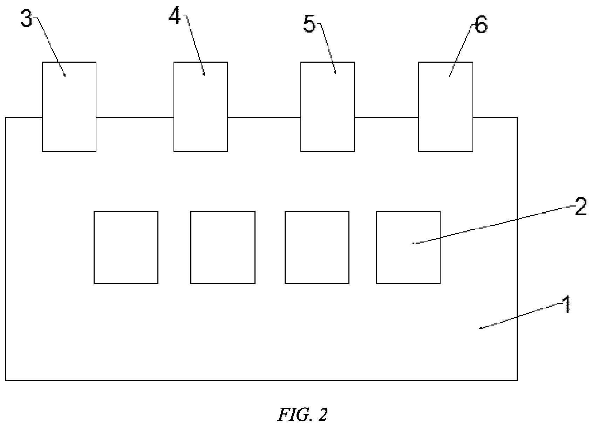

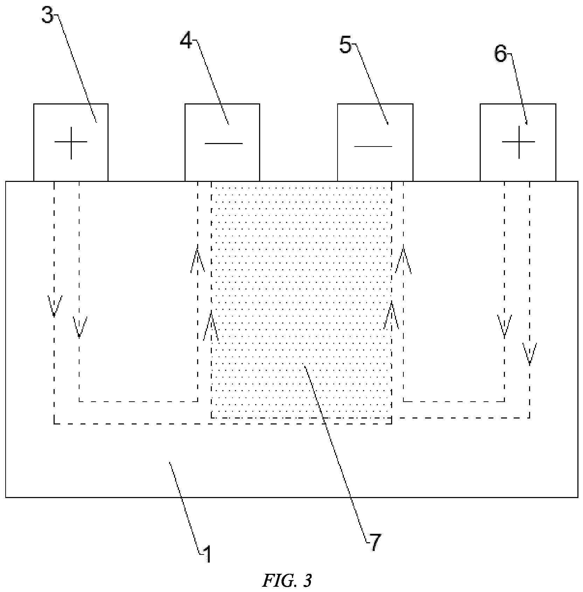

Accordingly, to solve the problem that the existing motor power modules have high stray inductance of a main loop, which results in the increase of loss during switching on and off and thus results in the increase of loss of the power module at high frequencies, resulting in incapability to meet the usage requirements, the invention provides a novel power module for an electric motor. Referring to FIGS. 2 and 3, the power module includes a substrate 1, a chip 2, a first positive terminal 3, a first negative terminal 4, a second negative terminal 5 and a second positive terminal 6, where the chip 2 is welded on the substrate 1, the first positive terminal 3, the first negative terminal 4, the second negative terminal 5 and the second positive terminal 6 are fixed to the substrate 1 by ultrasonic wire bonding; and the first positive terminal 3, the first negative terminal 4, the second negative terminal 5, and the second positive terminal 6 are fixed to a DC terminal of the power module.

According to the orientation in FIGS. 2 and 3, the first positive terminal 3, the first negative terminal 4, the second negative terminal 5, and the second positive terminal 6 are arranged in sequence from left to right, that is, the first negative terminal 4 and the second negative terminal 5 are located between the first positive terminal 3 and the second positive terminal 6, the first negative terminal 4 is adjacent to the first positive terminal 3, and the second negative terminal 5 is adjacent to the second positive terminal 6; and the first positive terminal 3, the first negative terminal 4, the second negative terminal 5 and the second positive terminal 6 are spaced apart by a preset distance that is designed according to design requirements.

It should be noted that the first positive terminal 3, the first negative terminal 4, the second negative terminal 5 and the second positive terminal 6 may be arranged in sequence from left to right. Alternatively, the first positive terminal 3, the first negative terminal 4, the second negative terminal 5 and the second positive terminal 6 may be arranged in sequence from right to left.

Continuing to refer to FIG. 3, a first current loop is formed between the first positive terminal 3 and the first negative terminal 4, and a second current loop is formed between the first positive terminal 3 and the second negative terminal 5.

Specifically, the first positive terminal 3 forms the first current loop with the first negative terminal 4 via the substrate 1 and the chip 2, and the first positive terminal 3 forms the second current loop with the second negative terminal 5 via the substrate 1 and the chip 2.

Continuing to refer to FIG. 3, a third current loop is formed between the second positive terminal 6 and the first negative terminal 4, and a fourth current loop is formed between the second positive terminal 6 and the second negative terminal 5.

Specifically, the second positive terminal 6 forms the third current loop with the first negative terminal 4 via the substrate 1 and the chip 2, and the second positive terminal 6 forms the fourth current loop with the second negative terminal 5 via the substrate 1 and the chip 2.

Continuing to refer to FIG. 3, the first current loop and the second current loop have the same current flow direction, the third current loop and the fourth current loop have the same current flow direction, and the third current loop and the fourth current loop have a current flow direction opposite to the current flow direction of the first current loop and the second current loop.

For example, according to the orientation in FIGS. 2 and 3, the current flow direction of the first current loop and the second current loop is a counter-clockwise direction, and the current flow direction of the third current loop and the fourth current loop is a clockwise direction. Certainly, if the current flow direction of the first current loop and the second current loop is a clockwise direction, the current flow direction of the third current loop and the fourth current loop is a counter-clockwise direction.

It should be noted that when the first positive terminal 3, the first negative terminal 4, the second negative terminal 5 and the second positive terminal 6 are arranged in sequence from left to right, the current flow direction of the first current loop and the second current loop is a counter-clockwise direction, and the current flow direction of the third current loop and the fourth current loop is a clockwise direction; and when the first positive terminal 3, the first negative terminal 4, the second negative terminal 5 and the second positive terminal 6 are arranged in sequence from right to left, the current flow direction of the first current loop and the second current loop is a clockwise direction, and the current flow direction of the third current loop and the fourth current loop is a counter-clockwise direction.

The second current loop and the third current loop can form an overlapping loop area 7 located between the first negative terminal 4 and the second negative terminal 5, and the second current loop and the third current loop have opposite current flow directions, such that the magnetic fluxes generated by the second current loop and the third current loop in the overlapping loop area 7 can cancel each other out.

In addition, although not shown in the figures, the power module of the invention further includes a plastic housing and a heat sink, where the plastic housing and the substrate 1 are both fixed to the heat sink, and the substrate 1 is encapsulated inside the plastic housing by an encapsulation adhesive. One ends of the first positive terminal 3, the second positive terminal 6, the first negative terminal 4 and the second negative terminal 5 extend to the outside of the plastic housing.

It should be noted that the substrate 1 may be a copper-clad ceramic substrate 1, and the chip 2 may be a power transistor chip 2 made of silicon carbide. However, those skilled in the will appreciate that the types of the substrate 1 and the chip 2 are not limited and may be other types.

With reference to the above implementations and various extended embodiments, according to the invention, the first negative terminal 4 and the second negative terminal 5 are arranged between the first positive terminal 3 and the second positive terminal 6, that is, compared with the prior art, one negative terminal is added on the basis of the power module of the same width, such that the overlapping area of the second current loop and the third current loop is increased to expand the magnetic flux cancellation region, which reduces the stray inductance of the main loop, in turn reduces the loss during switching on and off, and finally reduces the loss of the power module at high frequencies. That is, according to the invention, the influence of the stray inductance on the power module is reduced by changing the number and arrangement of the terminals, thereby improving that reliability of electric motor drive control.

Heretofore, the technical solutions of the invention have been described with reference to the preferred implementations shown in the accompanying drawings. However, those skilled in the art can readily understand that the scope of protection of the invention is apparently not limited to these specific implementations. Those skilled in the art may make equivalent changes or substitutions to the related technical features without departing from the principle of the invention, and all the technical solutions with such changes or substitutions shall fall within the scope of protection of the invention.

## Claims

1. A power module for an electric motor, **characterized in that** the power module comprises a first positive terminal, a first negative terminal, a second negative terminal and a second positive terminal which are arranged in sequence, wherein
a first current loop is formed between the first positive terminal and the first negative terminal, and a second current loop is formed between the first positive terminal and the second negative terminal; and
a third current loop is formed between the second positive terminal and the first negative terminal, and a fourth current loop is formed between the second positive terminal and the second negative terminal;
the first current loop and the second current loop have the same current flow direction, the third current loop and the fourth current loop have the same current flow direction, and the first current loop and the third current loop have opposite current flow directions; and
the second current loop and the third current loop are capable of forming an overlapping loop area located between the first negative terminal and the second negative terminal to enable cancellation of magnetic fluxes generated by the second current loop and the third current loop in the overlapping loop area.

2. The power module for an electric motor according to claim 1, **characterized in that** the current flow direction of the first current loop and the second current loop is a counter-clockwise direction, and the current flow direction in the third current loop and the fourth current loop is a clockwise direction.

3. The power module for an electric motor according to claim 1, **characterized in that** the first positive terminal, the first negative terminal, the second negative terminal and the second positive terminal are fixed to a DC terminal of the power module by ultrasonic wire bonding.

4. The power module for an electric motor according to claim 1, **characterized in that** the power module further comprises a substrate on which the first positive terminal, the first negative terminal, the second negative terminal and the second positive terminal are all fixed by ultrasonic wire bonding.

5. The power module for an electric motor according to claim 4, **characterized in that** the power module further comprises a chip welded on the substrate.

6. The power module for an electric motor according to claim 5, **characterized in that** the first positive terminal correspondingly forms the first current loop and the second current loop with the first negative terminal and the second negative terminal, respectively, via the substrate and the chip.

7. The power module for an electric motor according to claim 5, **characterized in that** the second positive terminal correspondingly forms the third current loop and the fourth current loop with the first negative terminal and the second negative terminal, respectively, via the substrate and the chip.

8. The power module for an electric motor according to claim 4, **characterized in that** the power module further comprises a plastic housing and a heat sink, wherein the plastic housing and the substrate are both fixed to the heat sink, and the substrate is encapsulated inside the plastic housing by an encapsulation adhesive.

9. The power module for an electric motor according to claim 8, **characterized in that** one ends of the first positive terminal, the second positive terminal, the first negative terminal and the second negative terminal extend to the outside of the plastic housing.

10. The power module for an electric motor according to claim 4, **characterized in that** the substrate is a copper-clad ceramic substrate.
